# EUROPÄISCHE PATENTSCHRIFT

(11) **EP 1 228 285 B1**
(45) Veröffentlichungstag und Bekanntmachung des Hinweises auf die Patenterteilung: **29.09.2004**
(21) Anmeldenummer: 00987037.9
(22) Anmeldetag: 24.10.2000
(51) Int. Cl.: E05F 15/16, H05K 3/00

(54) **ELEKTRONISCHE STEUERUNGSEINRICHTUNG ZUR ANSTEUERUNG ELEKTRISCHER AGGREGATE VON KRAFTFAHRZEUGTÜREN MIT UNTERSCHIEDLICHER AUSSTATTUNG**
ELECTRONIC CONTROL DEVICE FOR CONTROLLING ELECTRIC UNITS OF MOTOR VEHICLE DOORS WHICH HAVE DIFFERENT EQUIPMENT
DISPOSITIF ELECTRONIQUE POUR LA COMMANDE D'UNITES ELECTRIQUES DE PORTES DE VEHICULES POURVUES D'UN EQUIPEMENT DIFFERENT

(30) Priorität: 28.10.1999 DE 19951916
(43) Veröffentlichungstag der Anmeldung: 07.08.2002
(73) Patentinhaber: Brose Fahrzeugteile GmbH & Co. KG, 96450 Coburg (DE)
(72) Erfinder: ÜBELEIN, Jörg, 96271 Grub am Forst (DE); STETTER, Stephan, 96106 Ebern (DE); MAGER, Thorsten, 36318 Schwalmtal (DE); HOFMANN, Gerhard, 46049 Bamberg (DE)
(74) Vertreter: Baumgärtel, Gunnar, Dr.
(86) Internationale Anmeldenummer: PCT/DE2000/003803
(87) Internationale Veröffentlichungsnummer: WO 2001/031157

(56) Entgegenhaltungen:
- DE-A- 3 628 981
- US-A- 3 780 431
- US-A- 5 245 258
- US-A- 5 687 476

## Beschreibung

Die Erfindung bezieht sich auf eine elektronische Steuerungseinrichtung zur Ansteuerung elektrischer Aggregate von Kraftfahrzeugtüren mit unterschiedlicher Ausstattung gemäß dem Oberbegriff des Patentanspruchs 1.

Eine weitere elektronische Steuerungseinheit für einen Fensterheberantrieb wird in EP 0 482 040 B1beschrieben. Sie besitzt eine Leiterplatte mit einem zungenförmigen Fortsatz, an dessen freiem Ende elektrische Kontaktierungselemente zur Bestromung des Motors und Hall-Elemente zur Drehzahlerfassung positioniert sind. Die Leiterplatte wird von einem Gehäuse umschlossen, das im Bereich des zungenförmigen Fortsatzes offen ist und diesen Fortsatz frei gibt. Der Öffnung des Elektronikgehäuses steht die Öffnung eines Getriebegehäuses paßgenau gegenüber, so daß bei Abschluß der Montage die beiden Gehäuseteile ein gemeinsames abgeschlossenes Gehäuse bilden.

Die beschriebene elektronische Steuerungseinrichtung ist hinsichtlich ihrer Bestückung mit elektronischen Bauelementen und hinsichtlich ihrer gehäuseseitigen Schnittstellen eine sehr anwendungsspezifische technische Lösung, die an veränderte Anforderungen, wie z.B. an unterschiedliche Ausstattungsvarianten, nicht anpaßbar sind. Hierfür werden wiederum spezielle Elektronikvarianten entwickelt und produziert.

Der Erfindung liegt die Aufgabe zugrunde, eine elektronische Steuerungseinrichtung zur Ansteuerung elektrischer Aggregate von Kraftfahrzeugtüren derart weiterzuentwickeln, daß der Einsatz dieser Leiterplatte auch bei unterschiedlichen Ausstattungsvarianten der Fahrzeugtür in einfacher Weise möglich wird, wobei das Layout der Leiterplatte entsprechend den Ausstattungsvarianten im wesentlichen erhalten bleiben soll. Außerdem soll die Steuerungseinrichtung unterschiedlichen Integrations- und Kontaktierungsanforderung zu den anzusteuernden elektrischen Aggregaten gerecht werden.

Erfindungsgemäß wird die Aufgabe durch eine Steuerungseinrichtung gelöst, die für mindestens zwei Ausstattungsvarianten der Fahrzeugtür wenigstens einen identisch bestückten Bereich einer Leiterplatte verwendet, wobei die Leiterplatte einer der Ausstattungsvarianten eine Minderbestückung aufweist. Die Leiterplatte einer Ausstattungsvariante ist räumlich in ein Gehäuse eines zu steuernden Aggregats integriert, während die Leiterplatte einer anderen Ausstattungsvariante in einem separaten Gehäuse angeordnet ist.

Nach einer Vorzugsvariante der Erfindung sind die elektonischen Bauelemente, die der Ansteuerung eines elektrischen Aggregats (z.B. des Fensterhebermotors) oder mehrerer elektrischer Aggregate (z.B. elektrische Spiegelverstellung und Spiegelheizung) gemäß einer Ausstattungsvariante dienen, auf zusammenhängenden Bereichen der Leiterplatte angeordnet. Wenn diese zusammenhängenden Bereiche an den Rand der Leiterplatte angrenzen, besteht die Möglichkeit, bei einer Minderbestückung zur Einsparung von Material und Bauraum den nicht benötigten Bereich erst gar nicht vorzusehen bzw. von der Leiterplatte abzutrennen.

Eine andere Ausführungsform sieht vor, daß die elektronischen Bauelemente, die der Ansteuerung eines oder mehrerer elektrischer Aggregate gemäß einer Ausstattungsvariante dienen, auf einer separaten, kleineren Leiterplatte angeordnet sind, die durch Löten oder durch elektrische Steckverbinder an eine weitere Leiterplatte angeschlossen werden kann.

Gemäß einer weiteren Vorzugsvariante ist die Leiterplatte in einem offenen Gehäuse angeordnet, dessen öffnungsrand paßgenau mit dem Gehäuse wenigstens eines der anzusteuernden elektrischen Aggregate derart in Eingriff bringbar ist, daß die beiden offenen Gehäuse nach ihrer Kombination ein geschlossenes Gehäuse bilden. Bei einer entsprechenden Kombination eines elektrisch angetriebenen Fensterhebers mit der erfindungsgemäßen elektronischen Steuerungseinrichtung kann diese auf der Leiterplatte neben den Leistungsrelais auch die Mittel zur elektrischen Kontaktierung des Motors sowie die Sensorik tragen. Für den Fall, daß an der Motorwelle zur Generierung von Drehzahlsignalen ein Ringmagnet befestigt ist, so werden Hall-Sensoren an geeigneten Stellen der Leiterplatte plaziert. Der zur Bestromung vorgesehene und mit Sensorik ausgestattete Bereich der Leiterplatte sollte vorzugseise zungenförmig ausgebildet sein, um einen möglichst einfachen Eingriff in den Motorraum zu ermöglichen. Zur kabellosen elektrischen Kopplung des zu steuernden Aggregats mit der Leiterplatte kann aber auch ein Kontaktierungs- bzw. Koppelelement vorgesehen werden, das mit der Leiterplatte verbindbar ist und das die elektrischen Kontaktierungselemente sowie die Sensorik zur Drehzahlerfassung trägt. Ein solches Koppelelement kann beispielsweise als MIT-Teil ausgeführt sein.

Eine besonders raumsparende Variante sieht vor, daß das Gehäuse der Leiterplatte einen im wesentlichen L-förmigen Querschnitt aufweist, wobei ein erster Gehäuseschenkel möglichst flach ausgebildet ist und der Aufnahme der Leiterplatte dient. Der andere, vergleichsweise dickere zweite Gehäuseschenkel nimmt die elektrischen Steckverbinder auf, wobei die Steckelemente auf der Innenseite des Gehäuseschenkels angeordnet sind, so daß die Steckrichtung parallel zum anderen Gehäuseschenkel verläuft. Dadurch gelingt es in einfacher Weise, die elektronische Steuerungseinrichtung mit dem zu steuernden Aggregat räumlich zu verschachteln. Beispielsweise kann zwischen den beiden L-förmigen Gehäuseschenkeln das Polrohr eines Stabankermotors angeordnet werden.

Nachfolgend wird die Erfindung anhand von Ausführungsbeispielen sowie der dargestellten Figuren näher erläutert. Es zeigen:
- Figur 1: Leiterplatte mit mehreren Bereichen zur Aufnahme von elektronischen Bauelementen für unterschiedliche Ausstattungsvarianten;
- Figur 2: Basis-Leiterplatte mit mehreren Bereichen zur Aufnahme von elektronischen Bauelementen für unterschiedliche Ausstattungsvarianten und einer weiteren, damit verbindbaren separaten Leiterplatte zur kabellosen Kontaktierung eines Fensterhebermotors;
- Figur 3: Basis-Leiterplatte mit mehreren Bereichen zur Aufnahme von elektronischen Bauelementen für unterschiedliche Ausstattungsvarianten und einem damit verbindbaren separaten Koppelelement zur kabellosen Kontaktierung eines Fensterhebermotors;
- Figur 4: schematische Ansicht eines Antriebs mit Motor, Getriebe und elektronischer Steuerungseinrichtung;
- Figur 5: schematische Ansicht eines Schnitts durch eine elektronische Steuerungseinrichtung;

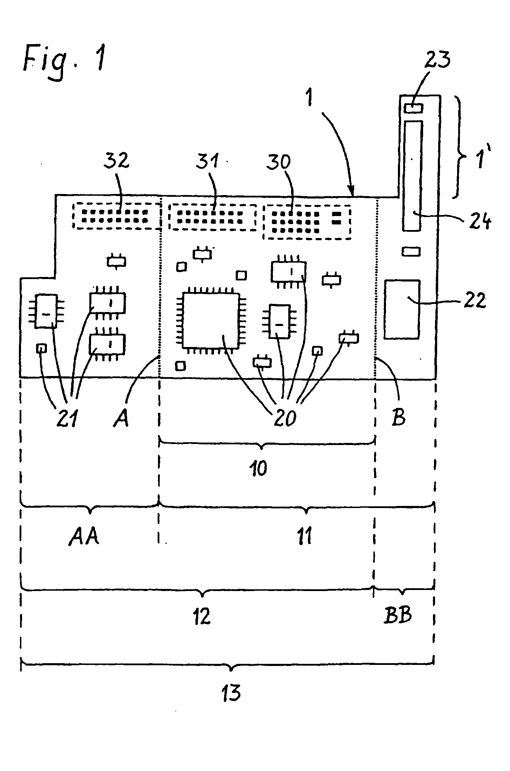

Das Ausführungsbeispiel von Figur 1 zeigt eine Leiterplatte 1 für eine elektronische Steuerungseinrichtung zur direkten Kontaktierung eines zu steuernden Aggregats, insbesondere eines mit einem Elektromotor betriebenen Fensterhebers, gemäß der vorgesehenen maximalen Ausstattungsvariante einer Fahrzeugtür: Demnach sind in einem zungenförmigen Bereich 1' die elektrischen Kontaktierungs- und Sensorelemente 23, 24 plaziert, die beim Zusammenfügen des Gehäuses des Antriebs und des Gehäuses der Steuerungseinrichtung in die vorgesehenen Positionen bezüglich des Motors gelangen. Unterhalb des zungenförmigen Bereichs 1' befindet sich ein Relais 22 zum Schalten des Leistungsstroms des Motors 5.

Jenseits der Bereichsgrenze B schließt sich ein Basisbereich 10 an, der an der Bereichsgrenze A endet und dessen elektronische Bauelemente 20 sowie die Stecker 30, 31 die Minimalbestückung entsprechend der minimal vorgesehenen Ausstattungsvariante der Fahrzeugtür repräsentieren. Dies könnte beispielsweise die Steuerung der Zentralverriegelung sein, wobei über den Stecker 30 die zentrale Stromversorgung und die Einbindung des Bus-Systems und über den Stecker 31 der Anschluß der in der Türinnenverkleidung angeordneten Taster und Schalter erfolgt.

Sollte man sich für eine solche Minimalausstattung (nur Zentralverriegelung) entscheiden, so bleibt die Leiterplatte 1 sinnvollerweise auf den Bereich 10 beschränkt und wird in einem separaten Elektronikgehäuse angeordnet. Dabei kann das Layout der entsprechenden Leiterplattenbereichs 10 gegenüber dem Layout eine höher ausgestatteten Leiterplatte 1 im wesentlichen unverändert bleiben; an den Bestückungsautomaten müssen keine Veränderungen vorgenommen werden. An dieser Stelle sei jedoch erwähnt, das natürlich auch bei einer Minderausstattung die für eine höherwertige oder die Maximalausstattung vorgesehene Leiterplatte 1 Verwendung finden kann. Dies könnte dann sinnvoll sein, wenn die betreffende Ausstattungsvariante so selten geordert wird, daß das Vorhalten einer weiteren Leiterplattengröße und gegebenenfalls eines weiteren Gehäuses unwirtschaftlich ist.

Der sich links von der Bereichsgrenze A anschließende Bereich AA trägt die elektronischen Bauelemente 21 für die Spiegelsteuerung und zugehörigen Stecker 32. Dieser Bereich AA stellt - ebenso wie der Bereich BB - keine selbständige Ausstattungsvariante dar, da die Stromversorgung sämtlicher Bereiche AA, BB, 10 über den Stecker 30 erfolgt.

Gemäß dem Ausführungsbeispiel der beschriebenen Leiterplatte 1 sind also folgende Ausstattungsvarianten realisierbar:
- Bei vollständiger Bestückung der Leiterplatte 1 (Bereich 13) ergibt sich die Maximalausstattung mit Ansteuerung von Zentralverriegelung, Fensterheber und Spiegel. Die Steuerungseinrichtung wird direkt mit dem Fensterheberantrieb elektrisch verbunden und in einem gemeinsamen Gehäuse untergebracht.
- Bei einem Verzicht auf den Bereich AA verbleibt ein Bestückungsbereich 11, der die Steuerung von Zentralverriegelung und Fensterheber repräsentiert. Auch in dieser Ausstattungsvariante erscheint eine direkte Verbindung der Leiterplatte 1 mit dem Fensterheberantrieb sinnvoll.
- Werden keine elektrisch betreibbaren Fensterheber geordert, so kann auf die Bestückung des Bereichs BB beziehungsweise auf diesen Bereich BB der Leiterplatte 1 verzichtet werden. Die Leiterplatte 1 dieser Ausstattungsvariante enthält also die Elemente zur Ansteuerung der Zentralverriegelung und des Spiegels und wird in einem separaten Gehäuse plaziert, so daß die Leiterplatte 1 keine direkte Verbindung (z.B. hergestellt durch Löten oder Stecken) zu einem der anzusteuernden Aggregate, also zu einem Schloß oder Spiegel, aufweist.
- Wie schon erwähnt, ergibt bei ausschließlicher Bestückung des Bereichs 10 die Minimalausstattung, bei der nur die Fahrzeugschlösser angesteuert werden. Auch in diesem Falle wird die Steuerungseinrichtung von einem separaten Gehäuse gefaßt.

Durch die Anordnung der den optionalen Ausstattungsmerkmalen zugeordneten elektronischen Bauelemente 21, 22, 23, 24 an die Ränder (Bereiche AA, BB) einer Basisausstattungsvariante gemäß dem Bereich 10 der Leiterplatte 1 gelingt es in einfacher Weise, den Material- und Herstellungsaufwand zur Erzeugung der verschiedenen Ausstattungsvarianten gegenüber herkömmlichen Methoden erheblich zu reduzieren. Gleichzeitig bleibt der Vorteil erhalten, die Leiterplatte direkt mit einem anzusteuernden Aggregat verbinden zu können, wenn dies beispielsweise aus Gründen der Sensorintegration in die Leiterplatte 1 gewünscht wird.

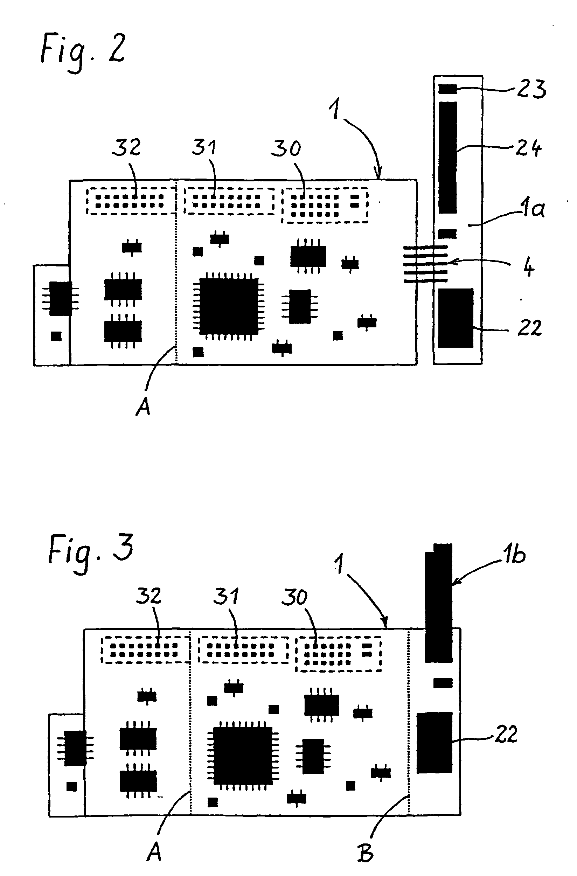

Die Ausführungsbeispiele der Figuren 2 und 3 unterscheiden sich hinsichtlich ihrer Funktionalität bzw. der möglichen Ausstattungsvarianten nicht. Sie besitzen lediglich konstruktive Unterschiede zur Erzeugung der beschriebenen Varianten.

So ist in Figur 2 eine separate Leiterplatte 1a mit Bauelementen 22, 23, 24 dargestellt, die ausschließlich in einem funktionellen Zusammenhang der Ansteuerung des Fensterheberantriebs stehen. Zur Verbindung der separaten Leiterplatte 1a mit der Basisleiterplatte 1 ist schematisch eine Verbindung 4 dargestellt, die durch Stecken oder Löten ausgeführt sein kann. Grundsätzlich kann auch an der Bereichsgrenze A eine solche Verbindung vorgesehen werden. Daraus ergibt sich der Vorteil, daß aus vorgefertigten Einzelleiterplatten die gewünschten, Ausstattungsvarianten beliebig zusammengesetzt werden können.

Das Ausführungsbeispiel von Figur 3 verwendet im Vergleich zu dem von Figur 1 anstatt des zungenförmigen Bereichs 1' der Leiterplatte 1 ein mit der Leiterplatte 1 durch Stecken verbindbares Koppelelement 1b, vorzugsweise in Form eines MID-Teils, das beispielsweise die Mittel elektrischen Motorkontaktierung und die Sensorik trägt.

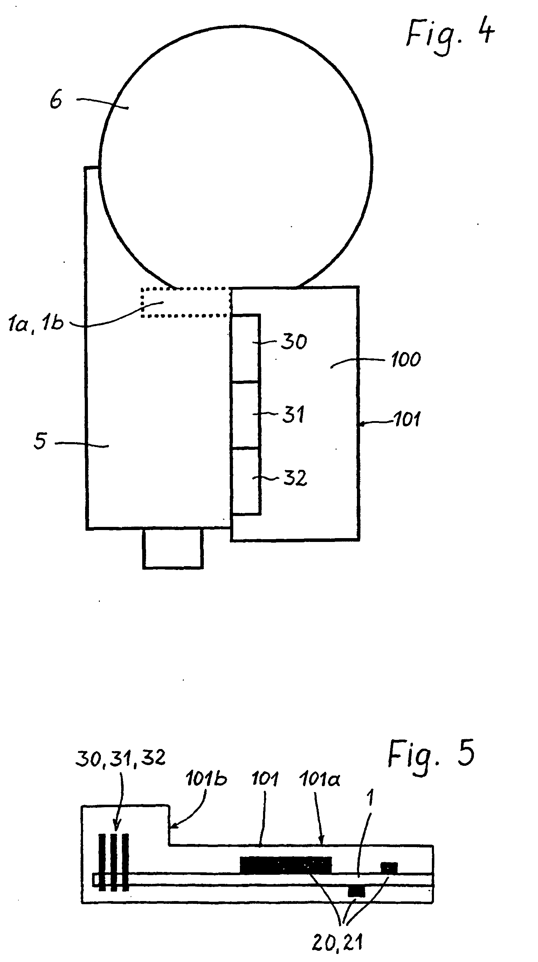

Figur 4 zeigt schematisch die Ansicht eines Fensterheberantriebs mit einem Stabankermotor, dessen (nicht dargestellte) Motorwelle mit einem Getriebe 6 in Wirkverbindung steht. Darüber hinaus ist angedeutet, daß ein zungenförmiger, mit der Leiterplatte 1 in Verbindung stehender Teil 1a, 1b in den Motorbereich eingreift und eine direkte elektrische Kopplung zwischen der Leiterplatte 1 und dem Motor 5 herstellt. Die elektrischen Stecker 30, 31, 32 grenzen unmittelbar an das Polrohr des Stabankermotors an.

In Figur 5 ist schematisch ein Querschnitt durch das Gehäuse 101 der elektronischen Steuerungseinrichtung 100 dargestellt. Das Gehäuse 101 besitzt eine L-förmige Kontur, wobei in dem vergleichsweise flachen Schenkel 101a die Leiterplatte 1 mit den elektronischen Bauteilen 20, 21 und in dem vergleichsweise breiten Schenkel 101b die Stecker 30, 31, 32 angeordnet sind. Gemäß dieser Darstellung ist eine quer zum Schenkel 101a verlaufende Steckrichtung vorgesehen. Allerdings können die Stecker 30, 31, 32 auch derart mit der Leiterplatte 1 verbunden werden, daß die Steckrichtung parallel zum Schenkel 101a an dessen Innenseite verläuft, wodurch bei Bedarf ein Höhenaufbau im Bereich des anderen Schenkels 101 b vermieden werden kann.

### Bezugszeichenliste

- 1: Leiterplatte
- 1': Zungenförmiger Bereich
- 1 a: Teil der Leiterplatte
- 1b: Koppelelement
- 10: Ausstattungsvariante, Bereich der Leiterplatte
- 11: Ausstattungsvariante, Bereich der Leiterplatte
- 12: Ausstattungsvariante, Bereich der Leiterplatte
- 13: Ausstattungsvariante, Bereich der Leiterplatte
- 100: elektronische Steuerungseinrichtung
- 101: Gehäuse
- 101a: Schenkel des Gehäuses
- 101b: Schenkel des Gehäuses

- 20: elektronisches Bauelement
- 21: elektronisches Bauelement
- 22: elektronisches Bauelement, Ralais
- 23: elektronisches Bauelement, Motorkontaktierung und/oder Sensorelement
- 24: elektronisches Bauelement

- 30: Stecker
- 31: Stecker
- 32: Stecker

- 4: Steckverbinder oder Lötverbindung
- 5: Motor
- 6: Getriebe

- A: Bereichsgrenze
- B: Bereichsgrenze
- AA: Bereich
- BB: Bereich

## Patentansprüche

1. Serie elektronischer Steuerungseinrichtungen zur Ansteuerung elektrischer Aggregate von Kraftfahrzeugtüren mit unterschiedlicher Ausstattung, wobei jede Steuerungseinrichtung der Serie von wenigstens einer mit elektronischen Bauelementen bestückten Leiterplatte gebildet ist, die über Steckverbinder mit einem Kabelbaum kontaktierbar und in einem Gehäuse angeordnet sind und wobei jeder Ausstattungsvariante (10, 11, 12, 13) der Fahrzeugtür eine Steuerungseinrichtung der Serie zugeordnet ist,
**dadurch gekennzeichnet,**
**daß** für mindestens zwei Ausstattungsvarianten (10, 11, 12, 13) der Fahrzeugtür unterschiedliche Steuerungseinrichtungen der Serie vorgesehen sind, deren Leiterplatten wenigstens einen identisch bestückten Bereich (10) aufweisen, wobei bei wenigstens einer der Ausstattungsvarianten (10, 11, 12) die Leiterplatte (1) eine Minderbestückung aufweist, und daß die Leiterplatte (1) einer Ausstattungsvariante (11, 13) räumlich in ein Gehäuse eines zu steuernden Aggregats integriert ist, während die Leiterplatte einer anderen Ausstattungsvariante (10, 12) in einem separaten Gehäuse angeordnet ist.

2. Serie elektronischer Steuerungseinrichtungen nach Anspruch 1, **dadurch gekennzeichnet, daß** die elektronischen Bauelemente (22, 23, 24), die der Ansteuerung eines elektrischen Aggregats (z.B. des Fensterhebermotors 5) oder mehrerer elektrischer Aggregate (z.B. elektrische Spiegelverstellung und Spiegelheizung) gemäß einer Ausstattungsvariante dienen, auf zusammenhängenden, vorzugsweise randseitigen Bereichen (AA, BB) der Leiterplatte (1) angeordnet sind.

3. Serie elektronischer Steuerungseinrichtungen nach Anspruch 2, **dadurch gekennzeichnet, daß** bei einer Minderbestückung der Leiterplatte (1) zur Einsparung von Material und Bauraum der nichtbestückte Bereich (AA, BB) nicht vorgesehen bzw. abgetrennt ist.

4. Serie elektronischer Steuerungseinrichtungen nach Anspruch 1, **dadurch gekennzeichnet, daß** die elektronischen Bauelemente (22, 23, 24), die der Ansteuerung eines elektrischen Aggregats (z.B. des Fensterhebermotors) oder mehrerer elektrischer Aggregate (z.B. elektrische Spiegelverstellung und Spiegelheizung) gemäß einer Ausstattungsvariante dienen, auf separaten, miteinander durch Löten oder Stecken verbindbaren Teilen (1a) der Leiterplatte (1) angeordnet sind.

5. Serie elektronischer Steuerungseinrichtungen nach wenigstens einem der voranstehenden Ansprüche, **dadurch gekennzeichnet, daß** das Gehäuse (101) der Leiterplatte (1) und das Gehäuse des zu steuernden elektrischen Aggregats (5, 6) offen und derart ausgebildet sind, daß diese zu einem gemeinsamen geschlossenen Gehäuse zusammengefügt werden können.

6. Serie elektronischer Steuerungseinrichtungen nach Anspruch 5, **dadurch gekennzeichnet, daß** zur kabellosen elektrischen Kopplung des zu steuernden elektrischen Aggregats (5) und der Leiterplatte (1) an der Leiterplatte (1) einteilig ein vorzugsweise zungenförmiger Bereich (1') angeformt ist, der die vorgesehenen. elektrischen Kontaktierungselemente (23) und gegebenenfalls eine Sensorik zur Drehzahlerfassung trägt.

7. Serie elektronischer Steuerungseinrichtungen nach Anspruch 5, **dadurch gekennzeichnet, daß** zur kabellosen elektrischen Kopplung des zu steuernden elektrischen Aggregats (5) und der Leiterplatte (1) ein mit der Leiterplatte (1) verbindbares Koppelelement (1 b) vorgesehen ist, das die elektrischen Kontaktierungselemente (23) und gegebenenfalls eine Sensorik zur Drehzahlerfassung trägt.

8. Serie elektronischer Steuerungseinrichtungen nach Anspruch 7, **dadurch gekennzeichnet, daß** das Koppelelement (1b) als MID-Teil ausgeführt ist.

9. Serie elektronischer Steuerungseinrichtungen nach wenigstens einem der voranstehenden Ansprüche, **dadurch gekennzeichnet, daß** das Gehäuse (101) der Leiterplatte (1) einen im wesentlichen L-förmigen Querschnitt aufweist, wobei ein Gehäuseschenkel (101a) vergleichsweise flach ausgebildet ist und der Aufnahme der Leiterplatte (1) dient, und der andere vergleichsweise dickere Gehäuseschenkel (101 b) auf seiner Innen- oder Stirnseite die elektrischen Steckverbinder (30, 31, 32) aufnimmt, wobei die Steckrichtung parallel beziehungsweise quer zum anderen Gehäuseschenkel (101a) verläuft.

10. Serie elektronischer Steuerungseinrichtungen nach wenigstens einem der voranstehenden Ansprüche, **dadurch gekennzeichnet, daß** das mit der Leiterplatte (1) direkt verbindbare elektrische Aggregat (5) ein mit einem Stabankermotor betriebener Fensterheber ist und daß der mit den Steckverbindern (30, 31, 32) ausgestattete Gehäuseschenkel (101b) in unmittelbarer Nähe zum Polrohr (5) des Stabankermotors und parallel dazu verläuft.

## Claims

1. Series of electronic control devices for controlling electric units of motor vehicle doors which have different equipment, each control device in the series being formed by at least one printed circuit-board comprising an assembly of electronic components which are arranged in a housing and can make contact with a cable assembly using plug-in connectors and each equipment variant (10, 11, 12, 13) of the vehicle door being provided with a control device from the series,
**characterised in that**
for at least two equipment variants (10, 11, 12, 13) of the vehicle door, different control devices of the series are provided, of which the printed circuit-boards comprise at least one zone (10) with an identical assembly of components, the printed circuit-board (1) having a reduced component assembly for at least one of the equipment variants (10, 11, 12) and **in that** the printed circuit-board (1) of one equipment variant (11, 13) is spatially integrated into a housing of a unit which is to be controlled while the printed circuit-board of another equipment variant (10, 12) is arranged in a separate housing.

2. Series of electronic control devices according to claim 1, **characterised in that** the electronic components (22, 23, 24) for controlling an electric unit (for example the window lifter motor 5) or a plurality of electric units (for example electric mirror adjustment and mirror heating) according to an equipment variant are arranged on connected zones (AA, BB) preferably at the edge of the printed circuit-board (1).

3. Series of electronic control devices according to claim 2, **characterised in that**, with a reduced component assembly on the printed circuit-board (1) to save material and space, the zone (AA, BB) without an assembly of components is not provided or is separated.

4. Series of electronic control devices according to claim 1, **characterised in that** the electronic components (22, 23, 24) for controlling an electric unit (for example the window lifter motor) or a plurality of electric units (for example electric mirror adjustment and mirror heating) according to an equipment variant are arranged on separate parts (1a) of the printed circuit-board (1) which may be mutually connected by soldering or plugging in.

5. Series of electronic control devices according to at least one of the preceding claims, **characterised in that** the housing (101) of the printed circuit-board (1) and the housing of the electric unit (5, 6) to be controlled are open and are so constructed that they may be joined together to form a common closed housing.

6. Series of electronic control devices according to claim 5, **characterised in that**, for cable-free electrical coupling of the electric unit (5) to be controlled and the printed circuit-board (1), a preferably tongue-like zone (1') carrying the proposed electric contact elements (23) and optionally sensor devices for speed detection is shaped integrally on the printed circuit-board (1).

7. Series of electronic control devices according to claim 5, **characterised in that**, for cable-free electrical coupling of the electric unit (5) to be controlled and the printed circuit-board (1) there is provided a coupler (1b) which may be connected to the printed circuit-board (1) and carries the electric contact elements (23) and optionally sensor devices for speed control.

8. Series of electronic control devices according to claim 7, **characterised in that** the coupler (1b) is designed as a MIT element.

9. Series of electronic control devices according to at least one of the preceding claims, **characterised in that** the housing (101) of the printed circuit-board (1) has a substantially L-shaped cross-section, one housing arm (101a) preferably having a flat construction for receiving the printed circuit-board (1) and the other comparatively thicker housing arm (101b) receiving the electric plug-in connectors (30, 31, 32) on its inner or end face, the plug-in direction extending parallel or transversely to the other arm of the housing (101a).

10. Series of electronic control devices according to at least one of the preceding claims, **characterised in that** the electric unit (5) which may be connected directly to the printed circuit-board (1) is a window lifter operated by a bar-wound armature motor and **in that** the housing arm (101b) equipped with the plug-in connectors (30, 31, 32) extends in the immediate vicinity of the pole tube (5) of the bar-wound armature motor and parallel thereto.

## Revendications

1. Série de dispositifs de commande électroniques pour la commande d'unités électriques pourvues d'un équipement différent dans des portes de véhicules automobiles, chaque dispositif de commande de la série étant formé par au moins une plaquette de circuits imprimés équipée de composants électroniques, qui peut être mise en contact avec un faisceau de câbles par l'intermédiaire de connecteurs et qui est agencée dans un boîtier, et un dispositif de commande de la série étant affecté à chaque variante d'équipement (10, 11, 12, 13) de la porte du véhicule, **caractérisée en ce que**, pour au moins deux variantes d'équipement (10, 11, 12, 13) de la porte du véhicule, il est prévu des dispositifs de commande différents de la série, dont les plaquettes de circuits imprimés comportent au moins une zone (10) équipée de manière identique, la plaquette de circuits imprimés (1), dans au moins l'une des variantes d'équipement (10, 11, 12), comportant un équipement minimum, et **en ce que** la plaquette de circuits imprimés (1) d'une variante d'équipement (11, 13) est intégrée à l'intérieur d'un boîtier d'une unité à commander, alors que la plaquette de circuits imprimés d'une autre variante d'équipement (10, 12) est agencée dans un boîtier séparé.

2. Série de dispositifs de commande électroniques selon la revendication 1, **caractérisée en ce que** les composants électroniques (22, 23, 24) qui, selon une variante d'équipement, ont pour fonction de commander une unité électrique (telle que le moteur du lève-vitre (5)) ou plusieurs unités électriques (telles que le réglage électrique du rétroviseur et le chauffage électrique du rétroviseur), sont agencés sur la plaquette de circuits imprimés (1) dans des zones (AA, BB) adjacentes, de préférence situées en bordure.

3. Série de dispositifs de commande électroniques selon la revendication 2, **caractérisée en ce que**, dans le cas d'un équipement minimum de la plaquette de circuits imprimés (1) en vue de réaliser des économies de matière et de place, la zone (AA, BB) non équipée n'est pas prévue ou est détachée.

4. Série de dispositifs de commande électroniques selon la revendication 1, **caractérisée en ce que** les composants électroniques (22, 23, 24) qui, selon une variante d'équipement, ont pour fonction de commander une unité électrique (telle que le moteur du lève-vitre) ou plusieurs unités électriques (telles que le réglage électrique du rétroviseur et le chauffage électrique du rétroviseur), sont agencés dans des zones (1a) séparées de la plaquette de circuits imprimés (1), lesquelles peuvent être assemblées les unes aux autres par brasage ou enfichage.

5. Série de dispositifs de commande électroniques selon l'une quelconque des revendications précédentes, **caractérisée en ce que** le boîtier (101) de la plaquette de circuits imprimés (1) et le boîtier de l'unité électrique (5, 6) à commander sont ouverts et sont conçus de telle sorte qu'ils peuvent être assemblés pour former un boîtier commun fermé.

6. Série de dispositifs de commande électroniques selon la revendication 5, **caractérisée en ce que**, pour le couplage électrique sans câble de l'unité électrique (5) à commander et de la plaquette de circuits imprimés (1), une zone (1'), de préférence en forme de languette, est formée d'un seul tenant contre la plaquette de circuits imprimés (1), laquelle zone porte les éléments de contact (23) électriques prévus et, le cas échéant, un système de capteurs pour l'enregistrement de la vitesse de rotation.

7. Série de dispositifs de commande électroniques selon la revendication 5, **caractérisée en ce que**, pour le couplage électrique sans câble de l'unité électrique (5) à commander et de la plaquette de circuits imprimés (1), il est prévu un élément de couplage (1b) destiné à être assemblé à la plaquette de circuits imprimés (1), lequel porte les éléments de contact (23) électriques prévus et, le cas échéant, un système de capteurs pour l'enregistrement de la vitesse de rotation.

8. Série de dispositifs de commande électroniques selon la revendication 7, **caractérisée en ce que** l'élément de couplage (1b) est conçu sous forme de composant MID.

9. Série de dispositifs de commande électroniques selon l'une quelconque des revendications précédentes, **caractérisée en ce que** le boîtier (101) de la plaquette de circuits imprimés (1) présente une section sensiblement en forme de L, une branche (101a) du boîtier étant relativement plate et étant destinée à recevoir la plaquette de circuits imprimés (1), et l'autre branche (101b) du boîtier étant relativement plus épaisse et portant sur sa face intérieure ou face frontale les connecteurs électriques (30, 31, 32), le sens de connexion étant parallèle ou transversal à l'autre branche (101a) du boîtier.

10. Série de dispositifs de commande électroniques selon l'une quelconque des revendications précédentes, **caractérisée en ce que** l'unité électrique (5), destinée à être assemblée directement à la plaquette de circuits imprimés (1), est un lève-vitre actionné par un moteur avec induit à barres, et **en ce que** la branche (101b) du boîtier, munie des connecteurs (30, 31, 32), s'étend à proximité immédiate du tube polaire (5) du moteur avec induit à barres et parallèlement à celui-ci.
